# EUROPEAN PATENT SPECIFICATION

(11) **EP 2 365 105 B1**
(45) Date of publication and mention of the grant of the patent: **24.10.2012**
(21) Application number: 11156750.9
(22) Date of filing: 03.03.2011
(51) Int. Cl.: C23C 16/54, C23C 16/34, C23C 16/455, B32B 7/02

(54) **Gas barrier film, film deposition method and film deposition device**
Gassperrfolie, Verfahren und Vorrichtung zur Filmabscheidung
Film formant barrière à gaz, procédé de dépôt de film et dispositif de dépôt de film

(30) Priority: 04.03.2010 JP 2010047595
(43) Date of publication of application: 14.09.2011
(73) Proprietor: Fujifilm Corporation, Minato-ku Tokyo (JP)
(72) Inventor: Mochizuki, Yoshihiko, Kanagawa (JP); Nishida, Hiroyuki, Kanagawa (JP)
(74) Representative: HOFFMANN EITLE

(56) References cited:
- EP-A1- 1 792 726
- EP-A1- 1 839 847
- EP-A1- 1 921 180
- US-A1- 2008 102 222
- US-A1- 2009 220 803
- US-A1- 2009 229 520
- US-A1- 2009 229 523

## Description

### BACKGROUND OF THE INVENTION

The present invention relates to a gas barrier film comprising a silicon nitride layer as a gas barrier layer and a film deposition method and device suitable for producing the gas barrier film.

A gas barrier film formed having a gas barrier layer (a water-vapor barrier layer) deposited on a base film is used not only in such positions or parts requiring moisture resistance in various devices including optical devices, displays such as liquid-crystal displays and organic EL displays, semiconductor manufacturing devices, and thin-film solar cells, but also in packaging materials used to package food, clothing, electronic components, and the like.

Among known gas barrier layers are those formed of various materials such as silicon oxide, silicon oxynitride, and aluminum oxide. An example of such known gas barrier layers is a silicon nitride layer composed primarily of silicon nitride (SiN). Known methods of producing a gas barrier layer composed primarily of silicon nitride include plasma-enhanced CVD.

In addition to excellent gas barrier properties, gas barrier layers are required to possess various other properties according to the performance required of gas barrier films, applications for which they are intended, and the like. Excellent adhesion to the base film for sufficient mechanical strength and excellent productivity are among such properties required.

To meet such various requirements, gas barrier layers each having different characteristics are laminated to form a single gas barrier layer as is practiced in the art.

For example, JP 2002-105649 A describes a film deposition device comprising a feed chamber and a take-up chamber for feeding and rewinding a long length of base film in the form of a web, and a film deposition chamber provided between these chamber for depositing a layer on a base film under vacuum in the film deposition chamber, wherein the film deposition chamber includes a plurality of film deposition means including those using plasma-enhanced CVD method, and wherein a material gas (process gas) supply section is provided in each of film deposition sections comprising film deposition means and separated by insulation partitions.

This film deposition device achieves deposition of a gas barrier layer composed of different kinds of layers by changing the kind of material gas supplied to the film deposition sections and permits adjustment of film quality by adjusting the distance between the partitions.

JP 2009-31612 A describes a gas barrier layer composed of a first silicon nitride layer (SiN layer) formed by CVD at a starting temperature of 50°C or higher (preferably higher than 170°C) and a second silicon nitride layer deposited on the first silicon nitride layer by CVD at a starting temperature of 170°c or lower.

The gas barrier layer described in JP 2009-31612 A excels in adhesion to the resin base film as well as gas barrier properties.

EP-A-1 792 726 teaches a transparent gas barrier film comprising a substrate having thereon a gas barrier layer. The gas barrier layer comprises, from the substrate side, a low density layer, an intermediate layer, and a high density layer. These layers may be formed from silicon nitride.

### SUMMARY OF THE INVENTION

However, because the film deposition device described in JP 2002-105649 A requires a plurality of film deposition means and film deposition sections to form a plurality of layers having different properties, the whole device necessarily assumes increased dimensions.

In addition, a gas barrier film formed by depositing a silicon nitride layer often exhibits insufficient adhesion to the base film.

On the other hand, because the gas barrier layer described in JP 2009-31612 A includes the first silicon oxide film that is formed at a temperature of 170°C or higher, the starting temperature for film deposition is limited depending on the resin base film used. Therefore, there are cases where deposition of a dense silicon nitride layer having sufficient gas barrier properties may not be achieved. Should the base film be damaged due to heat, sufficient adhesion between the base film and the silicon nitride layer cannot be obtained.

In addition, quickly changing the base film temperature is extremely difficult. Accordingly, deposition of a gas barrier layer as described in the JP 2009-31612 A involving only a single rewind necessarily requires a plurality of film deposition means (film deposition sections) as in the film deposition device described in JP 2002-105649 A. In addition, a sufficient interval for adjusting the base film temperature is required between the operations of the film deposition means depending on the starting temperature for depositing the second silicon nitride layer.

An object of the present invention is to overcome the above problems associated with the prior art and provides a gas barrier film excelling in adhesion to the base film as well as gas barrier properties and enabling high productivity and a film deposition method and device suitable for producing the gas barrier film.

According to a first aspect, the present invention provides a gas barrier film comprising:
a base film; and
a silicon nitride layer deposited on a surface of the base film,
wherein in the thickness direction of the silicon nitride layer, the mean density of a first region of the silicon nitride layer closer to the base film and having a 20% thickness of the silicon nitride layer is higher than the mean density of a second region opposite from the base film and having a 20% thickness of the silicon nitride layer, and the mean density of a middle, third region having a 20% thickness of the silicon nitride layer lies between the mean densities of the first and second regions.

According to a second aspect, the present invention provides a method for preparing a gas barrier film according to the above first aspect comprising the steps of:
transporting a base film in a given direction;
flowing a gas which generates SiH₂ and SiH₃ silane radicals in the same direction as the base film transport direction; and
depositing a silicon nitride layer on a surface of the base film by plasma-enhanced CVD using silane radicals generated from the gas, the silicon nitride of the first region being deposited in the presence of a relatively high proportion of SiH₂ radicals and the silicon nitride of the second region being deposited in the presence of a relatively high proportion of SiH₃ radicals.

According to a third aspect, the present invention provides a film deposition device comprising:
means for transporting a base film in a given direction;
means for depositing a film including a gas introduction means for introducing gas from which silane radicals can be generated and a plasma generating means; and
a gas flow creating means for creating a gas flow in the same direction as the transport direction of the base film selected from at least one of:
   (i) a gas blocking means provided on the upstream side of the gas introduction means relative to the base film transport direction,
   (ii) a discharge passage for discharging the gas on the downstream side of the gas introduction means relative to the base film transport direction, and
   (iii) the gas introduction means also acts as the gas flow creating means and wherein the gas flow is created by introducing more gas on the upstream side, relative to the base film transport direction, than on the downstream side.

### BRIEF DESCRIPTION OF THE DRAWINGS

Fig. 1 is a schematic view showing a gas barrier film according to an embodiment of the present invention.
Fig. 2 is a graph schematically showing distributions of the density of a silicon nitride layer formed on a gas barrier film of the invention and of a conventional gas barrier film.
Fig. 3 is a schematic view showing a film deposition device of the invention for implementing the film deposition method.
Figs. 4A to 4C illustrate examples of material gas flow creating means which can be used in the film deposition device shown in Fig. 3.
Figs. 5A to 5C are schematic views for explaining the differences in base film coverage properties due to the difference in silane plasma.

### DETAILED DESCRIPTION OF THE INVENTION

Now, the method for producing a gas barrier film, a film deposition method, and a film deposition device according to the present invention will be described in detail below referring to the accompanying drawings.

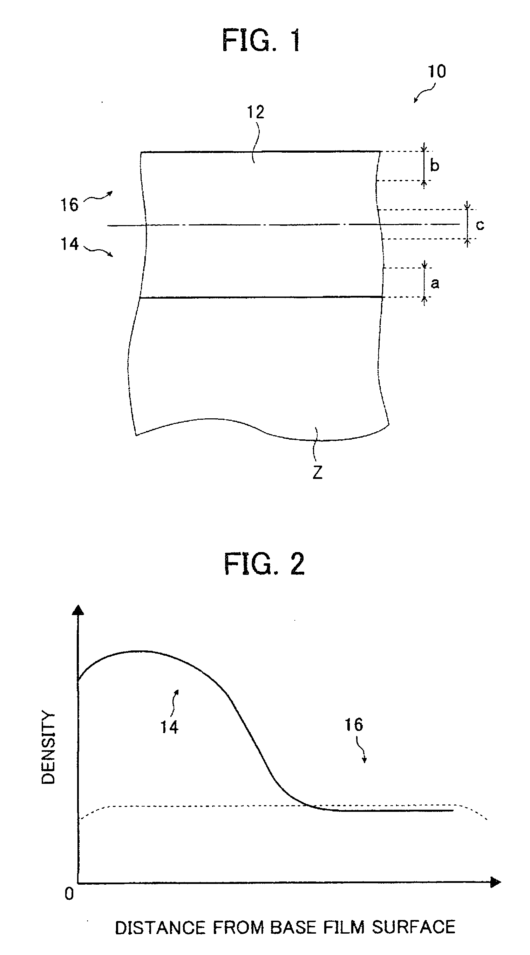

Fig. 1 is a schematic view showing a gas barrier film 10 according to an embodiment the present invention.

As illustrated in Fig. 1, the gas barrier film 10 is formed by depositing a silicon nitride layer 12 as gas barrier layer on a base film Z.

In the gas barrier film 10, the base film Z is not specifically limited and may be any of sheet materials of various kinds that allow the silicon nitride layer 12 to be deposited by plasma-enhanced CVD.

Specific examples of the base film Z that may be advantageously used include plastic films (resin films) made of organic materials such as polyethylene terephthalate, polyethylene naphthalate (PEN), polyethylene, polypropylene, polystyrene, polyamide, polyvinyl chloride, polycarbonate, polyacrylonitrile, polyimide, polyacrylate, and polymethacrylate.

The base film Z to be used in the present invention may also be any of sheet materials formed of a base material such as any of those plastic films and a layer deposited thereon for imparting various functions, such as a protective layer, an adhesive layer, a light-reflecting layer, a light-shielding layer, a planarizing layer, a buffer layer, and a stress-relief layer.

The base film Z may be a sheet material having a single layer formed on a base material or a sheet material having a plurality of layers deposited on a base material. When the base film Z is a sheet material having a plurality of layers deposited on a base material, the same layer may be deposited in a plurality of layers or one or more layers may be silicon nitride layers that are deposited by the film deposition method (device) of the invention.

The gas barrier film 10 has a silicon nitride layer 12 formed on the surface of the base film Z.

The silicon nitride layer 12 comprises a high density region 14 in a lower position closer to the base film Z deposited in the presence of a great proportion of SiH₂ radicals and a low density region 16 having a low density in an upper position closer to the top side opposite from the base film Z deposited in the presence of a great proportion of SiH₃ radicals.

Specifically, the gas barrier film 10 of the invention comprises a lower region with a thickness of 20% indicated by arrow a in Fig. 1 having a mean density higher than the mean density of an upper region closer to the top side with a thickness of 20% indicated by arrow b, and a middle region with a thickness of 20% indicated by arrow c having a mean density between those of the lower and the upper regions a and b.

According to the invention, there may be cases where the interfaces between the adjacent regions of the silicon nitride layer 12 depending on the surface roughness of the base film Z may not be clear.

In such cases, the variation in composition in the film thickness direction may be measured by ESCA (Electron Spectroscopy for Chemical Analysis) to determine interfaces between adjacent layers where the N composition decreases and settles at a minimum and where the Si composition increases and settles at a maximum, and the interfaces thus determined may be used to detect the mean densities of the lower 20%-thickness layer, the upper 20%-thickness layer, and the middle 20%-thickness layer of the silicon nitride layer 12.

A typical silicon nitride layer is formed in the presence of a great proportion of SiH₃ radicals throughout the whole region in the thickness direction. Accordingly, the density of a typical silicon nitride layer is constantly low substantially throughout the whole region in the thickness direction as conceptually shown by the dotted line in Fig. 2.

By contrast, the gas barrier film 10 of the invention has a composition such that, as indicated by the solid line in Fig. 2, the high density region 14 in a lower position deposited in the presence of a great proportion of SiH₂ radicals and the low density region 16 having a low density in an upper position deposited in the presence of a great proportion of SiH₃ radicals, the middle region between them having a density between those of the lower and upper layers. With such a composition of the deposited layer, the present invention achieves production of the gas barrier film 10 excelling in adhesion between the base film Z and the silicon nitride layer 12 and productivity as well as gas barrier properties.

This will be described later in further detail.

The thickness of the silicon nitride layer 12 may be appropriately determined without any specific limitation according to such conditions as gas barrier properties and flexibility required of gas barrier films, applications for which the use of the film is intended, and the like, and is preferably 10 nm or more.

The silicon nitride layer 12 preferably has a mean density of 2.1 to 2.7 [g/cm³] in the 20%-thick lower region a and a mean density of 1.7 to 2.1 [g/cm³] in the 20%-thick upper region b as shown in Fig. 1.

The composition of these regions having mean densities in such ranges allows favorable results to be obtained including improved adhesion between the base film Z and the silicon nitride layer 12 and improved coverage properties during film deposition.

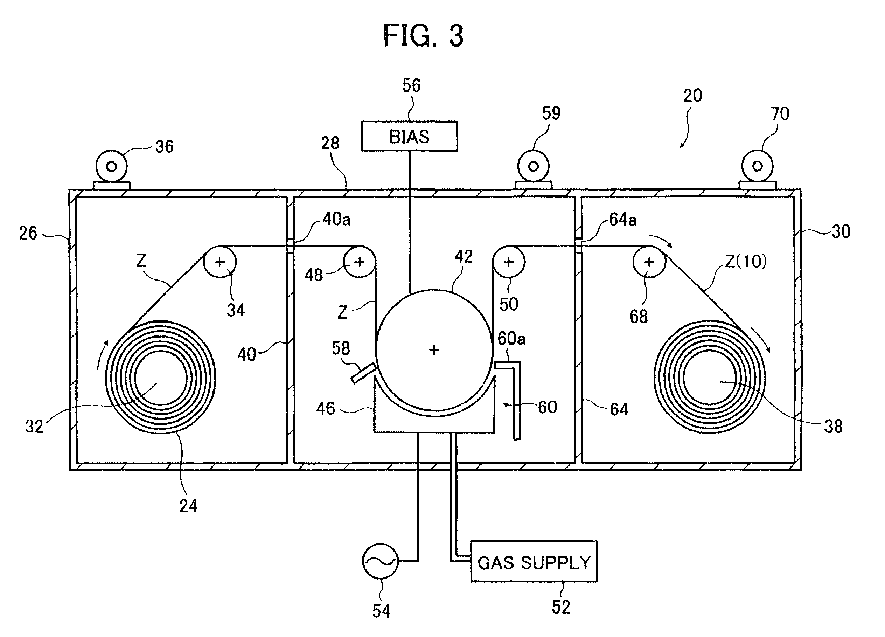

Fig. 3 schematically shows a film deposition device 20 for implementing a film deposition method to produce the gas barrier film 10 of the invention.

The illustrated film deposition device 20 produces the gas barrier film 10 by depositing or forming the silicon nitride layer 12 by CCP (capacitively coupled plasma)-CVD on the surface of a long length of base film Z or a film material in the form of a web as it is transported in a longitudinal direction.

The film deposition device 20 is a so-called roll-to-roll type film deposition device whereby the base film Z is fed from a base film roll 24, which is a roll of base film Z, the silicon nitride layer 12 is formed on the base film Z traveling in the longitudinal direction, and the base film having the silicon nitride layer 12 formed thereon, that is, the gas barrier film 10, is rewound into a roll.

While a long length of sheet material as illustrated is a preferred example of the base film Z in the film deposition device 20 (film deposition method) of the invention, cut sheets cut to a given length may also be preferably used.

While the illustrated film deposition device 20 achieves deposition of the silicon nitride layer 12 by CCP-CVD, the present invention is not limited this way. Specifically, the invention permits use of various film deposition methods including ICP (Inductively Coupled Plasma)-CVD, microwave CVD, ECR (Electron Cyclotron Resonance), and atmospheric pressure plasma CVD, provided that the material gas flow is created in the same direction as the base film transport direction.

Among others, illustrated CCP-CVD described later may be advantageously used as it uses shower head electrode 46 having a plane opposite the base film Z to readily create a gas flow in film deposition region in the same direction as the base film transport direction.

As described above, the film deposition device 20 shown in Fig. 3 is a so-called roll-to-roll film deposition device whereby the base film Z is fed from the base film roll 24, which is a roll of base film Z, and the silicon nitride layer 12 is formed on the base film Z traveling in the longitudinal direction before being rewound into a roll. The film deposition device 20 includes a feed chamber 26, a film deposition chamber 28 and a take-up chamber 30.

In addition to the illustrated members, the film deposition device 20 may also have various members of a roll-to-roll type device achieving film deposition by plasma CVD including various sensors, and various members (transport means) for transporting the base film Z along a predetermined path, as exemplified by a pair of transport rollers and a guide member for regulating the position in the width direction of the base film Z. In addition, the film deposition device 10 may include a plurality of the same or different plasma CVD film deposition chambers. Alternatively, at least one film deposition chamber for depositing a film by any of other vapor deposition techniques than plasma-enhanced CVD, flash evaporation or sputtering and/or at least one surface treatment chamber for plasma treatment may be connected to the film deposition device.

The feed chamber 26 includes a rotary shaft 32, a guide roller 34 and a vacuum evacuation means 36.

The base film roll 24 with a long length of base film Z wound thereon is mounted on the rotary shaft 32 in the feed chamber 26.

Upon mounting of the base film roll 24 on the rotary shaft 32, the base film Z is transported along a predetermined travel path starting from the feed chamber 26 and passing through the film deposition chamber 28 to reach a take-up shaft 38 of the take-up chamber 30.

Feeding of the base film Z from the base film roll 24 and winding of the base film Z on the take-up shaft 38 in the take-up chamber 30 are carried out in synchronism in the film deposition device 20 to continuously form the silicon nitride layer 12 on the long length of base film Z in the film deposition chamber 28 by CCP-CVD as the base film Z travels in its longitudinal direction along the predetermined travel path.

In the feed chamber 26, the rotary shaft 32 is rotated by a drive source (not shown) in a clockwise direction in Fig. 1 so that the base film Z is fed from the base film roll 24, guided by the guide roller 34 along the predetermined path and passes through a slit 40a provided in a partition wall 40 to reach the film deposition chamber 28.

In the preferred embodiment of the illustrated film deposition device 20, the feed chamber 26 and the take-up chamber 30 are provided with vacuum evacuation means 36 and 70, respectively. The vacuum evacuation means are provided in these chambers to ensure that these chambers have the same degree of pressure (vacuum) during film deposition as the film deposition chamber 28 described later so that the pressures inside these neighboring chambers do not affect the degree of vacuum inside the film deposition chamber 28 (deposition of the silicon nitride layer 12).

The vacuum evacuation means 36 is not particularly limited, and exemplary means that may be used include vacuum pumps such as a turbo pump, a mechanical booster pump, a dry pump, and a rotary pump, an assist means such as a cryogenic coil, and various other known (vacuum) evacuation means which use a means for adjusting the ultimate degree of vacuum or the amount of air discharged and are employed in vacuum deposition devices. In this regard, the same applies to other vacuum evacuation means 59 and 70 described later.

As described above, the base film Z is guided by the guide roller 34 to reach the film deposition chamber 28 through the slit 40a of the partition wall 40.

The film deposition chamber 28 is provided to deposit or form the silicon nitride layer 12 on the surface of the base film Z by CCP-CVD. In the illustrated embodiment, the film deposition chamber 28 includes a drum 42, a shower head electrode 46, guide rollers 48 and 50, a gas supply means 52, an RF power source 54, a bias power source 56, a gas blocking means 58, and the vacuum evacuation means 59.

The drum 42 in the film deposition chamber 28 is a cylindrical member rotating counterclockwise about the central axis in Fig. 1, and the base film Z guided by the guide roller 48 along the predetermined path is passed over a predetermined region of the peripheral surface to travel onward in the longitudinal direction as the base film Z is held in a given position facing the shower head electrode 46 to be described later.

The drum 42 also serves as a counter electrode in CCP-CVD and forms a pair of electrodes with the shower head electrode 46.

Therefore, the drum 42 is connected with the bias power source 56. The bias power source 56 may be any of various known current sources used as bias power source for CCP-CVD such as a 400 kHz RF power source.

The present invention is not limited this way, however. The drum 42 may be connected to ground or may be selectively connected to ground and the bias power source 56.

While the illustrated example comprises the RF power source 54 for supplying plasma excitation power to the shower head electrode 46 described later, the present invention is not limited this way. Specifically, the RF power source 54 for supplying plasma excitation power may be connected to the drum 42, with the shower head electrode 46 connected to ground, to achieve film deposition by so-called self-bias type CCP-CVD. Alternatively, the drum 42 may be connected with the RF power source 54, with the shower head electrode 46 connected to the bias power source 56. Alternatively, the drum 42 may be connected to the RF power source 54, with the shower head electrode 46 selectively connected to the bias power source 56 or ground.

Further, film deposition according to the invention is preferably carried out while adjusting the temperature of the base film Z (heating/cooling). Therefore, drum 42 preferably comprises a temperature adjusting means.

The temperature adjusting means of the drum 42 is not particularly limited and various types of temperature adjusting means may be used including one containing a refrigerant or a heating agent circulating in the drum and a cooling means using a piezoelectric element.

The shower head electrode 46 is of a known type used in film deposition achieved by CCP-CVD.

In the illustrated example, the shower head electrode 46 is, by way of example, hollow and has a substantially rectangular shape, with one external plane thereof being inwardly curved into a shape forming a part of the inner periphery of a cylinder having a radius greater than that of the drum 42. The shower head electrode 46 is so disposed that the rotation axis of the drum 42 and the central axis of the curved plane coincide to keep the curved plane away from the opposite periphery of the drum 42 by the same distance throughout the curved plane. In other words, the difference in radius between them corresponds to the distance separating them, so that the gap between them remains constant.

The curved plane of the shower head electrode 46 has numerous through-holes for emitting a material gas evenly distributed in the whole area of a region that has at least a chance of facing the base film Z.

The shower head electrode 46 has a length in the drum axial direction (i.e., the direction normal to the base film transporting direction, which will also be referred to below as "width-wise" direction) exceeding a maximum width of the base film Z and preferably slightly exceeding the size of the drum 42 in the width direction.

Further, the shower head electrode 46 may comprise a wall-like shield member at its upstream end for preventing emission of a material gas from the gap between the upstream end of the shower head electrode 46 and the drum 42.

The shower head electrode 46 according to the invention is not limited to the illustrated type having the curved plane and may be hollow and have a rectangular shape (hollow plate member) or may have a curved shape not parallel to the periphery of the drum.

Thus, the present invention allows any of known shower head electrodes used in CCP-CVD.

In the illustrated example, one shower head electrode (film deposition means using CCP-CVD) is provided in the film deposition chamber 28. However, the present invention is not limited to this configuration and a plurality of shower head electrodes may be disposed in the base film transport direction.

Further, the present invention is not limited to a configuration using the shower head electrode and allows a configuration comprising nozzles or the like for supplying a material gas provided between an electrode without the material gas emission holes (material gas supply means) and a counter electrode to achieve CCP-CVD.

The gas supply means 52 is of a known type used in vacuum deposition devices such as plasma CVD devices, and supplies a material gas (process gas) into the shower head electrode 46.

As described above, a large number of through holes are formed in the surface (curved plane) of the shower head electrode 46 facing the drum 42. Therefore, the material gas supplied into the shower head electrode 46 passes through the through holes to be introduced into the space between the shower head electrode 46 and the drum 42.

The film deposition device 20 (film deposition method) of the invention uses material gas containing a gas for producing silane radicals (SiH₂ and SiH₄) to achieve deposition of the silicon nitride layer 12.

Preferred gases for producing silane radicals may be selected from various silane gases.

Examples of such gases include silane [SiH_{4]}, monomethyl silane [MMS CH₃SiH₃], dimethyl silane [DMS (CH₃)₂SiH₂)], trimethyl silane [(CH₃) ₃SiH], tetramethyl silane [TMS (CH₃)₄Si], tetraethoxysilane [TEOS (C₂H₅O) 4Si], triethoxysilane [TRIES (C₂H₅O) ₃SiH], methyl triethoxysilane [(C₂H₅O) ₃SiCH₃], dimethyl diethoxysilane [(C₂H₅O) ₂Si (CH₃)₂], tetramethoxysilane [(CH₃O) ₄Si], diethyl silane [(C₂H₅) ₂SiH₂], triethyl silane [(C₂H₅) ₃SiH], diethoxymethyl silane [(C₂H₅O) ₂SiH(CH₃)], methyl trimethoxysilane [(CH₃O) ₃SiCH₃], dimethyl dimethoxysilane [(CH₃O) ₂Si (CH₃)₂], methyl trichlorosilane [CH₃SiC1₃], methyl dichlorosilane [(CH₃)HSiCl₂], dimethyl dichlorosilane [DDMS (CH₃)₂SiCl₂], trimethyl chlorosilane [TMCS (CH₃)₃SiCl], dichloroethyl silane [(C₂H₅)HSiCl₂], bis tertiary-butyl amino silane [BTBAS], HMDSO [(CH₃)₃SiOSi(CH₃)₃], and fluoroalkyl silane

The gas supply means 52 feeds a material gas containing one or more of these gases to the shower head electrode 46.

The material gas that may be any of various gases as appropriate including a known gas used for deposition of a silicon nitride layer using gas that produces the above-mentioned silane radicals and a combination of gases.

Examples of the material gas include a combination of silane gas, ammonia gas, and hydrogen gas; a combination of silane gas, ammonia gas, nitrogen gas, and hydrogen gas; a combination of silane gas and ammonia gas; a combination of silane gas and nitrogen gas; and any of these combinations to which helium or argon is added as diluent gas.

The RF power source 54 supplies plasma excitation power to the shower head electrode 46. Known RF power sources used in various plasma CVD devices can be all used for the RF power source 54 including a power source that supplies 13.56 MHz RF electricity.

As described above, the present invention permits use of various configurations in addition to one where the shower head electrode 46 is supplied with plasma excitation power, one example thereof being a self bias type where the drum 42 is supplied with plasma excitation power while the shower head electrode 46 is connected to ground.

The vacuum evacuation means 59 evacuates the film deposition chamber 14 to keep it at a predetermined film deposition pressure for deposition of the silicon nitride layer 12 by plasma-enhanced CVD, and is of a known type used in vacuum deposition devices as described above.

The film deposition chamber 28 comprises the gas blocking means 58 adjacent an upstream end of the shower head electrode 46 in the base film transport direction. Hereinafter, "downstream in the base film transport direction" is also referred to simply as "downstream," and the opposite stream as "upstream." Downstream of the shower head electrode 46 is disposed a wall member 60a to provide a gas discharge passage 60 for discharging the material gas.

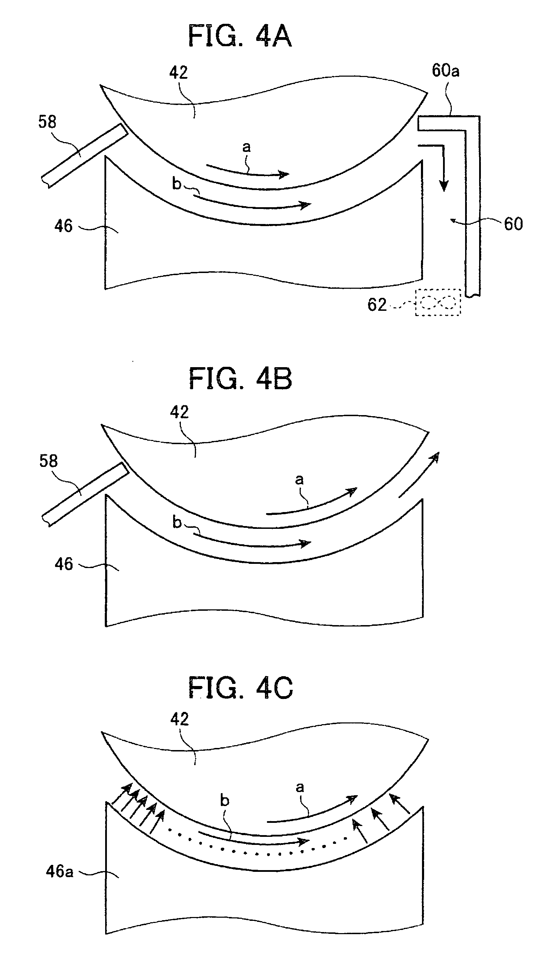

The gas blocking means 58 is a sheet member disposed with an end thereof as close to the drum 42 and a plane thereof as close to the upstream end of the shower head electrode 46 as the configuration permits, as schematically illustrated in Fig. 4A by way of example. The gas blocking means 58 has a width-wise length longer than the shorter of the width-wise lengths of the drum 42 and the shower head electrode 46.

The gas blocking means 58 may be disposed in contact with the shower head electrode 46. The gas blocking means 58 may be provided in the shower head electrode 46.

Thus, the gas blocking means 58 substantially closes the gap between the shower head electrode 46 and the drum 42 at the upstream end of the shower head electrode 46 to prevent the material gas from discharging from this position. The gas discharge passage 60 formed by the wall member 60a guides the material gas discharged downstream of the shower head electrode 46 at the gap between the shower head electrode 46 and the drum 42 toward an appropriate flow passage.

The film deposition chamber 28 equipped with the gas blocking means 58 and the gas discharge passage 60 allows a gas flow of the material gas (also referred to below simply as material gas flow) to be created in the direction indicated by arrow b, which is the same direction as the base film transport direction (direction in which the drum 42 turns) indicated by arrow a in Fig. 4, in the film deposition region, which is the region where the shower head electrode 46 and the drum 42 face each other in the illustrated example.

According to the film deposition device 20 (film deposition method), the silicon nitride layer 12 is deposited on the surface of the base film by plasma-enhanced CVD as the base film Z is transported while the material gas flow is created in the same direction as the base film transport direction, as described above.

Having such a configuration, the present invention enables production of the gas barrier film 10 of the invention having the silicon nitride layer 12 deposited thereon comprising the lower high-density region 14 and the upper low-density region and excelling in adhesion to the base film A and productivity with a single deposition means. When, by way of example, the CCP-DVD as illustrated is used, the gas barrier film 10 of the invention can be produced with a pair of electrodes consisting of a gas material supply means and another electrode.

In the deposition of a silicon nitride layer by plasma-enhanced CVD using, for example, silane as material gas, plasma produces silane radicals, which act as a precursor film that reacts with nitrogen radicals (nitrogen containing radicals) produced from other material gases to form a silicon nitride layer.

The silane radicals thus produced are primarily SiH₂ radials and SiH₃ radials. According to a study by the present inventors, a silicon nitride layer produced in the presence of highly reactive SiH₂ radicals existing in a great proportion in the silicon nitride layer deposition process accompanied by production of silane radicals has a high density and excels in adhesion to the base film.

A silicon nitride layer produced in the presence of SiH₃ radicals existing in a great proportion in the silicon nitride layer deposition process accompanied by production of silane radicals excels in coverage capability, with the density not so high as the above film, however. Further, it is thought that SiH₃ radicals act as precursor film in most of the silicon nitride layer deposition processes using typical CCP-CVD.

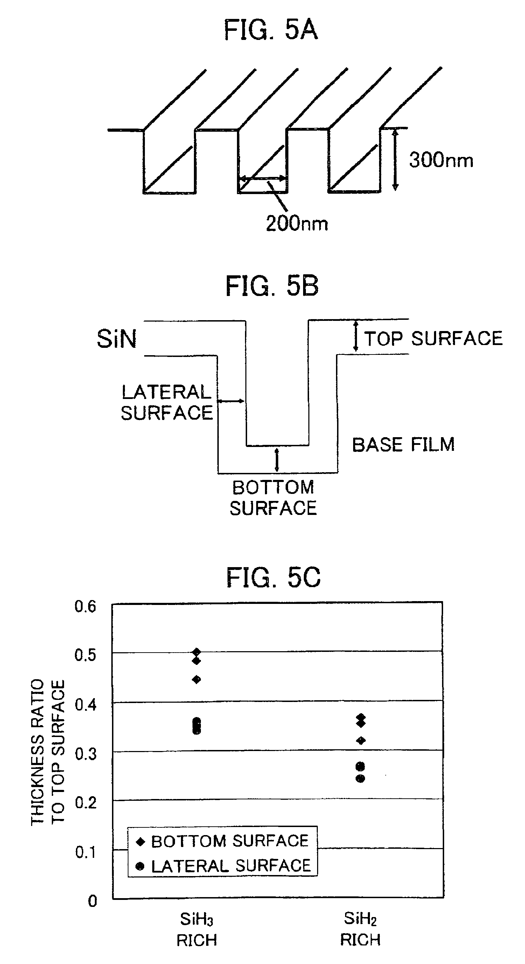

Fig. 5 shows base film coverage characteristics for comparison between film deposition in the presence of SiH₃ radicals existing in a great proportion (SiH₃ rich conditions) and film deposition in the presence of SiH₂ radicals existing in a great proportion (SiH₂ rich conditions).

In the comparison was used a trench base film as illustrated in Fig. 5A having corrugations each measuring 200 nm in width and 300 nm in height (depth). A silicon nitride layer was deposited on the trench base film under SiH₃-rich conditions and SiH₂-rich conditions to evaluate the base film coverage characteristics based on a ratio of the thickness of the film deposited on the lateral and bottom surfaces of the corrugations to the thickness of the film deposited on the top surface of the corrugations as conceptually illustrated in Fig. 5B. The material gas used included silane gas, ammonia gas, nitrogen gas and hydrogen. The electric current and gas flow rate were adjusted to provide SiH₃-rich and SiH₂-rich conditions.

The results given in Fig. 5C show that the film deposited under SiH₃-rich conditions has a thickness on both the lateral and bottom surfaces that are closer to the thickness thereof on the top surface as compared with the film deposited under SiH₂-rich conditions and excels the film deposited under SiH₂-rich conditions in base film coverage characteristics.

Accordingly, the gas barrier film 10 of the invention that excels in adhesion to the base film Z, i.e., mechanical strength, and productivity as well as gas barrier properties and comprises a lower high-density region 14 and an upper low-density region 16 by first carrying out film deposition in the presence of SiH₂ radicals existing in a great proportion, followed by film deposition in the presence of SiH₃ radicals existing in a great proportion.

On the other hand, the study by the present inventors shows that when plasma exists in a high density, i.e., as the material gas exists in a great quantity, SiH₂ radicals tend to be readily produced, whereas as the density of plasma decreases, i.e., as the material gas is consumed, SiH₃ radicals tend to be produced with an increased readiness.

In silicon nitride layer deposition accompanied by generation of silane radicals, highly reactive SiH₂ radicals are consumed by film deposition earlier than SiH₃ radicals as described above.

Further, SiH₂ radicals change into SiH₃ radicals as they hit other radicals or as time passes.

Accordingly, transporting the base film Z in a given direction indicated by arrow a in Fig. 4A and generating a material gas in the same direction indicated by arrow b as the base film transport direction causes SiH₂ radicals to be generated by high density plasma on the upstream side, increasing the proportion in which these radicals exist. Further, because SiH₂ radicals are consumed more readily for film deposition as described above, the amount of SiH₂ radicals, which are consumed earlier, decreases from upstream to downstream, thus increasing the ratio of SiH₃ existing in the silane radicals. Further, the ratio of SiH₃ existing in the silane radicals increases toward downstream also because the chance of SiH₂ radicals changing into SiH₃ radicals increases from upstream to downstream.

Along the length of the transported base film Z, the material gas is used for deposition of the silicon nitride layer under conditions where SiH₂ radicals exist in a great proportion on the upstream side (in the starting stage of film deposition, in the lower position of the layer, i.e., in a position closer to the base film), as the proportion of SiH₂ radicals gradually decreases toward the downstream side whereas the proportion of SiH₃ radicals gradually increases, so that the material gas is used for deposition of the silicon nitride layer under conditions where SiH₃ radicals exist in a great proportion on the upstream side (in the terminating stage of film deposition, in a position closer to the top surface).

Achieving silicon nitride layer deposition with concurrent base film transport and material gas flow, the present invention enables production of the gas barrier film 10 of the invention having excellent properties described above with a single deposition means using plasma-enhanced CVD, wherein the deposited silicon nitride layer 12 comprises the lower high-density region 14 and the upper low-density region and has a density distribution as illustrated in Fig. 2 where the density in a middle region exhibits a density between the densities of the lower and upper regions. When, by way of example, the CCP-DVD as illustrated is used, the gas barrier film 10 of the invention can be produced with a pair of electrodes consisting of a gas material supply means and another electrode.

Thus, the production method of the invention achieves production of the gas barrier film 10 of the invention while aiming at simplification and reduction in size of the device, improved productivity resulting therefrom, cost reduction, and the like. Further, the configuration needing only one film deposition means allows the film deposition means to be of larger dimensions than with a configuration requiring a plurality of film deposition means, thus enabling improvement on productivity.

As described above, the shower head electrode 46 is of a known type used in film deposition employing CCP-CVD.

A typical shower head electrode 46 of this kind is so designed as to allow a material gas to evenly reach the whole area of the film deposition region. To that end, the material gas is allowed to flow both upstream and downstream from the center of the shower head electrode 46 with respect to the transport direction in film deposition through typical CCP-CVD that does not use the gas blocking member 58. As a result, SiH₂ radicals exist in a greater proportion near the center whereas SiH₃ radicals exist in a greater proportion in regions close to the upstream and downstream ends. However, because the shower head electrode 46 supplies the material gas evenly throughout the whole film deposition region, the material gas flow is slow, and the difference in proportion in which both radicals exist in respective film deposition regions in the base film transport direction is small. Further, while there is such a proportion distribution, it is thought that silicon nitride layer deposition by typical CCP-CVD is achieved mostly by SiH₃ radicals as described above.

Thus, the silicon nitride layer produced by typical CCP-CVD has a consistently low density throughout the whole region as indicated by the dotted line in Fig. 2. Further, because SiH₃ radicals, whose reactivity is relatively not high, act as primary precursor film in the film deposition process, the adhesion of the silicon nitride layer to the base film Z is often insufficient.

The method of creating the material gas flow in the same direction as the base film transport direction according to the invention is not limited to the method illustrated in Fig. 4A and may be any of various methods as appropriate depending on the configuration of the film deposition device.

As indicated by the dotted line in Fig. 4A, for example, the gas discharge passage 60 may be provided with a suction means 62 such as a fan to actively discharge the material gas and thereby create a gas flow. Alternatively, the material gas flow may be created by means of the gas discharge passage 60 and the suction means 62 without using the gas blocking means 58. Alternatively, the suction means 62 may be the only means to create the material gas flow.

Alternatively, the gas blocking means 58 may be the only means to create the material gas flow without the gas discharge passage 60 provided, as illustrated in Fig. 4B.

Alternatively, the shower head electrode may have such a configuration wherein material emission holes are provided with a high density upstream and with a lower density downstream than upstream so as to make a difference between upstream and downstream in the amount of introduced material gas in order to create a material gas flow in the same direction as the transport direction (direction a) as in the shower head electrode 46a as illustrated in Fig. 4C in lieu of the shower head electrode 46 where the material gas emission holes are evenly distributed along the film deposition region. In such a configuration, the density of the gas emission holes may gradually decreases from upstream to downstream or the gas emission holes may be provided in a given upstream region, a given downstream region, and other regions of the shower head electrode with the densities decreasing from upstream region through said other region to the downstream region. Alternatively, the material gas emission holes may be provided only in a given upstream region.

Still alternatively, the inside of the shower head electrode, provided evenly with material gas emission holes, may be divided into regions, and the amounts of material gas supplied to these divided regions may be so adjusted as to make a difference in the amount of introduced material gas between upstream and downstream thereby to create the material gas flow in the same direction as the transport direction.

Further, the above configurations may be combined as appropriate to create the material gas flow in the same direction as the transport direction.

According to the invention, the film deposition conditions such as the material gas supply amount and the magnitude of the plasma excitation power are not specifically limited. The film deposition conditions may be determined as appropriate according to required film deposition speed, final film thickness, the kind of base film Z, and the like as in silicon nitride layer deposition using typical plasma-enhanced CVD. To adequately produce SiH₂ radicals, a certain level of plasma excitation power is required, preferably in a range of 1 W/cm² to 8 W/cm².

The material gas flow rate is also not specifically limited and may be determined as appropriate by conducting experiments and simulations under conditions according to the base film transport speed, required gas barrier film properties, and the like.

The difference in density between the low-density region 14 and the high-density region 16 can be adjusted by changing, for example, the material gas flow rate, base film Z transport speed, the length of the film deposition region (along the transport direction of the shower head electrode), supplied electric power, and the like.

As described above, the base film Z guided by the guide roller 48 is passed over the peripheral surface of the drum 42 and held in given positions along the transport path as it is transported along the longitudinal direction. Between a pair of electrodes consisting of the drum 42 and the shower head electrode 46, plasma is excited as the shower head electrode 46 is supplied with plasma excitation power, whereupon the material gas yields radicals, and the silicon nitride layer 12 is deposited by CCP-CVD on the surface of the base film Z that, supported by the drum 42 and transported further onward.

The base film Z having the silicon nitride layer 12 deposited thereon (i.e., gas barrier film 10) is then guided by the guide roller 50 and transported through the slit 64a of the partition wall 64 to enter the take up chamber 30.

In the illustrated embodiment, the take-up chamber 30 includes the guide roller 68, the take-up shaft 38, and the vacuum evacuation means 70.

The base film Z (gas barrier film) having reached the take-up chamber 30 travels to the take-up shaft 38 as it is guided by the guide roller 68 and is wound on the take-up shaft 38 to form a roll, which is then supplied to the subsequent step as a roll of gas barrier film.

The take-up chamber 30 is also provided with the vacuum evacuation means 70 as in the above-described feed chamber 26 and during film deposition, its pressure is reduced to a degree of vacuum suitable for the film deposition pressure in the film deposition chamber 28.

The operation of the film deposition device 20 is described below.

Upon mounting of the base film roll 24 on the rotary shaft 32, the base film Z follows a given transport path as it is reeled out from the base film roll 24, and is guided by the guide roller 34 from the feed chamber 26 to reach the film deposition chamber 28, where the base film Z is guided by the guide roller 48, passed over a predetermined region of the peripheral surface of the drum 42 and guided by the guide roller 50 to reach the take-up chamber 30, where the base film Z is guided by a guide roller 68 to reach the take-up shaft 38.

Subsequently, the vacuum evacuation means 36, 59, and 70 are actuated to reduce the chambers to their given pressures.

When the degrees of vacuum in the chambers stabilize, the gas supply means 52 supplies the shower head electrode 46 with the material gas in the film deposition chamber 28.

When the pressure in the film deposition chamber 28 settles down to a given pressure for deposition of the silicon nitride layer 12 by CCP-CVD, the base film Z starts to be transported from the feed chamber 26 toward the take-up chamber 30 while the RF power source 54 starts to supply the shower head electrode 46 with plasma excitation power and, optionally, the bias current source 56 starts to supply the drum 42 with bias current.

The base film Z transported from the feed chamber 26 to the film deposition chamber 28 is guided by the guide roller 48 and transported onward as it is passed over the drum 42 while the silicon nitride layer 12 is deposited by CCP-CVD in the region where the drum 42 and the shower head electrode 46 face.

The film deposition chamber 26 comprises the gas blocking means 58 at the upstream end of the shower head electrode 46 in the base film transport direction to prevent material gas discharge from the gap between the drum 42 and the shower head electrode 46. Thus, material gas flow is created during film deposition process in the same direction as the transport direction. As a result, the silicon nitride layer 12 is deposited which, as described above, comprises the lower high-density region 14 and the upper low-density region and exhibits a density distribution as indicated by the solid line in Fig. 2.

The base film Z having the silicon nitride layer 12 deposited thereon, i.e., gas barrier film 10, is then guided by the guide roller 50 and transported to the take-up chamber 30.

The base film Z having reached the take-up chamber 30 is guided by the guide roller 68 along a given path and rewound by the take-up shaft 30 into a roll, which is then supplied to the subsequent step as the gas barrier film 10.

While the gas barrier film, the film deposition device, and the film deposition method according to the present invention has been described above in detail, the present invention is by no means limited to the foregoing embodiments and it should be understood that various improvements and modifications may of course be made without departing from the scope and of the invention.

### <Working Example 1>

The film deposition device 20 as illustrated in Fig. 3 was used to deposit a silicon nitride layer on the base film Z to produce a gas barrier film.

The base film Z used was a 100 µm-thick PEN film provided by Teijin DuPont Films Japan Limited.

The material gas used included silane gas (SiH₄), ammonia gas (NH₃), and hydrogen gas (H₂). The supply amounts of silane gas, ammonia gas, and hydrogen gas were 200 sccm, 500 seem, and 1200 sccm, respectively.

The shower head electrode 46 was supplied with plasma excitation power having a frequency of 13.5 MHz and an output of 2W/cm². The drum 42 was adjusted to a temperature of 40°C and supplied with a bias current having a frequency of 400 kHz and an output of 600 W.

The film deposition pressure was 30 Pa; the base film transport speed was 1 m/min.

Under the above film deposition conditions, the silicon nitride layer with a thickness of 50 nm was deposited on the surface of the base film Z to produce the gas barrier film 10.

The produced gas barrier film was measured by Rutherford backscattering/hydrogen forward scattering analysis (RBS/HFS) to determine the mean densities in the lower 20%-thickness region closer to the base film (indicated by arrow a in Fig. 1), the upper 20%-thickness region closer to the top surface (indicated by arrow b in Fig. 1), and the middle 20%-thickness region between them (indicated by arrow c in Fig. 1) of the silicon nitride layer 12.

The mean densities in the lower region, the top surface region, and the middle region were 2.3 [g/cm³), 1.90 [g/cm³], and 2.1 [g /cm³], respectively.

### <Working Example 2>

A gas barrier film was produced in the same manner as in Working Example 1 except that the shower head electrode 46, which has the gas emission holes evenly provided throughout the whole surface, was replaced by a shower head electrode 46a as illustrated in Fig. 4C, where the gas emission density is higher upstream than downstream, and that the gas blocking member 58 and the gas discharge passage 60 are not provided.

More specifically, the shower head electrode 46a was divided into an upstream 20%-length region, a downstream 20%-length region, and the other region or middle region. The upstream region was provided with 50% more material gas emission holes than in the middle region; the downstream region was provided with 50 % fewer material gas emission holes than in the middle region.

The material gas emission holes differed only in density between the regions and were evenly provided in the respective regions. Their size was identical in all the regions.

The thickness of the silicon nitride layer 12 was 50 nm, which was the same as that in working Example 1.

The mean densities in the respective regions were measured in the same manner as in Working Example 1: the mean densities in the lower region, the top surface region, and the middle region were 2.3 [g/cm³], 1.90 [g/cm³], and 2.1 [g/cm³] respectively.

### <Working Example 3>

A gas barrier film was produced in the same manner as in Working Example 1 except that the shower head electrode 46 was connected to ground and not supplied with plasma excitation power whereas the drum 42 was supplied with plasma excitation power having a frequency of 13.5 MHz and an output of 2W/cm² (self-bias configuration).

The thickness of the silicon nitride layer 12 was 50 nm, which was the same as that in Working Example 1.

The mean densities in the respective regions were measured in the same manner as in Working Example 1: the mean densities in the lower region, the top surface region, and the middle region were 2.4 4 [g/cm³], 2.0 [g/cm³], and 2.2 [g/cm³], respectively.

### <Comparative Example 1>

A gas barrier film was produced in the same manner as in Working Example 1 except that the gas blocking member 58 and the gas discharge passage 60 (wall member 60a) were not provided. The thickness of the silicon nitride layer 12 was 50 nm, which was the same as that in Working Example 1.

The mean densities in the respective regions were measured in the same manner as in Working Example 1: the mean densities in the lower region, the top surface region, and the middle region were 1.9 [g/cm³], 2.0 [g/cm³], and 1. 9 [g/cm³], respectively.

The gas barrier films thus produced were evaluated for gas barrier properties and adhesion of the gas barrier layer 12.

### [Gas Barrier Properties]

The moisture vapor transmission rate [g/(m^{2.}day)] was measured by the MOCON method.

Those samples which exceeded the limit for measurement of the moisture vapor transmission rate by the MOCON method were measured for the moisture vapor transmission rate by the calcium corrosion method (see JP 2005-283561 A).

### [Adhesion of Silicon Nitride Film]

The silicon nitride layers were examined for adhesion to the base film Z by a cross-cut test according to JIS K5600. The adhesion was rated in a scale of 0 to 5 according to JIS-K5600 as follows:
0 to 1: Excellent
2 or more: Poor

The results are shown in Table 1.

**Table 1**

| | Mean density [g/cm³] | | | Gas barrier properties | Adhesion |
|---|---|---|---|---|---|
| | lower | middle | upper | | |
| Working Example 1 | 2.3 | 2.1 | 1.9 | <1 x 10⁻⁴ | Excellent |
| Working Example 2 | 2.3 | 2.1 | 1.9 | <1 x 10⁻⁴ | Excellent |
| Working Example 3 | 2.4 | 2.2 | 2.0 | <1 x 10⁻⁴ | Excellent |
| Comparative Example 1 | 1.9 | 2.0 | 1.9 | >1 x 10⁻³ | Poor |

As shown in Table 1, the gas barrier film of the invention produced by the production device (method) according to the invention excels the comparative examples produced by conventional methods in not only gas barrier properties but adhesion of the silicon nitride layer, the a gas barrier layer, to the base film.

The above results clearly show the beneficial effects of the present invention.

The present invention may be advantageously applied to gas barrier films used in various displays such as liquid crystal displays, solar cells, and the like and to production of these gas barrier films.

## Claims

1. A gas barrier film comprising:
a base film; and
a silicon nitride layer deposited on a surface of the base film,
wherein in the thickness direction of the silicon nitride layer, the mean density of a first region of the silicon nitride layer closer to the base film and having a 20% thickness of the silicon nitride layer is higher than the mean density of a second region opposite from the base film and having a 20% thickness of the silicon nitride layer, and the mean density of a middle, third region having a 20% thickness of the silicon nitride layer lies between the mean densities of the first and second regions.

2. A gas barrier film according to Claim 1, wherein the mean density of the first region is 2.1 - 2.7 g/cm³ and the mean density of the second region is 1.7 - 2.1 g/m³.

3. A method for preparing a gas barrier film according to Claim 1 comprising the steps of:
transporting a base film in a given direction;
flowing a gas which generates SiH₂ and SiH₃ silane radicals in the same direction as the base film transport direction; and
depositing a silicon nitride layer on a surface of the base film by plasma-enhanced CVD using silane radicals generated from the gas, the silicon nitride of the first region being deposited in the presence of a relatively high proportion of SiH₂ radicals and the silicon nitride of the second region being deposited in the presence of a relatively high proportion of SiH₃ radicals.

4. A method according to Claim 3, wherein the silicon nitride layer is deposited by CCP-CVD.

5. A method according to Claim 4, wherein the gas is introduced through a shower head electrode having a plurality of gas emission holes.

6. A method according to any of Claims 3 to 5, wherein the gas flow is created by providing a blocking means for blocking the flow of gas on the upstream side, relative to the base film transport direction, of where the gas is introduced.

7. A method according to any of Claims 3 to 6, wherein the gas flow is created by providing a discharge passage for discharging the gas on the downstream side, relative to the base film transport direction, of where the gas is introduced.

8. A method according to any of Claims 3 to 7, wherein the gas flow is created by introducing more gas on the upstream side, relative to the base film transport direction, than on the downstream side.

9. A method according to any of Claims 3 to 8, comprising depositing the silicon nitride layer while a long length of base film is transported in a longitudinal direction.

10. A film deposition device comprising:
means for transporting a base film in a given direction;
means for depositing a film including a gas introduction means for introducing gas from which silane radicals can be generated and a plasma generating means; and
a gas flow creating means for creating a gas flow in the same direction as the transport direction of the base film selected from at least one of:
(i) a gas blocking means provided on the upstream side of the gas introduction means relative to the base film transport direction,
(ii) a discharge passage for discharging the gas on the downstream side of the gas introduction means relative to the base film transport direction, and
(iii) the gas introduction means also acts as the gas flow creating means and wherein the gas flow is created by introducing more gas on the upstream side, relative to the base film transport direction, than on the downstream side.

11. A film deposition device according to Claim 10, wherein the plasma generating means includes a pair of electrodes.

12. A film deposition device according to Claim 11, wherein one of the pair of the electrodes is a shower head electrode having a plurality of gas emission holes for the gas.

13. A film deposition device according to any of Claims 10 to 12, wherein the transport means includes a cylindrical drum over whose peripheral surface a long length of base film is passed to transport the base film in a longitudinal direction thereof.

## Patentansprüche

1. Gassperrfolie, umfassend:
eine Basisfolie; und
eine Siliziumnitridschicht, die auf einer Oberfläche der Basisfolie abgeschieden ist,
worin, in Dickenrichtung der Siliziumnitridschicht, die mittlere Dichte eines ersten Bereichs der Siliziumnitridschicht, der näher an der Basisfolie ist und 20 % der Dicke der Siliziumnitridschicht ausmacht, höher ist als die mittlere Dichte eines zweiten Bereichs, der der Basisfolie gegenüberliegt und 20 % der Dicke der Siliziumnitridschicht ausmacht, und worin die mittlere Dichte eines mittleren, dritten Bereichs, mit 20 % der Dicke der Siliziumnitridschicht, zwischen den mittleren Dichten des ersten und zweiten Bereichs liegt.

2. Gassperrfolie gemäß Anspruch 1, worin die mittlere Dichte des ersten Bereichs 2,1 bis 2,7 g/cm³ beträgt und die mittlere Dichte des zweiten Bereichs 1,7 bis 2,1 g/m³ beträgt.

3. Verfahren zur Herstellung einer Gassperrfolie gemäß Anspruch 1, umfassend die Schritte:
Transportieren einer Basisfolie in eine gegebene Richtung;
Fließenlassen eines Gases, welches SiH₂- und SiH₃-Silanradikale generiert, in der gleichen Richtung wie die Basisfolien-Transportrichtung; und
Abscheiden einer Siliziumnitridschicht auf einer Oberfläche der Basisfolie durch plasmaverstärktes CVD unter Verwendung von Silanradikalen, die aus dem Gas gebildet werden, wobei das Siliziumnitrid des ersten Bereichs in der Gegenwart eines relativ großen Anteils von SiH₂-Radikalen abgeschieden wird und das Siliziumnitrid des zweiten Bereichs in der Gegenwart eines relativ großen Anteils von SiH₃-Radikalen abgeschieden wird.

4. Verfahren gemäß Anspruch 3, worin die Siliziumnitridschicht durch CCP-CVD abgeschieden wird.

5. Verfahren gemäß Anspruch 4, worin das Gas durch eine Duschkopfelektrode mit einer Vielzahl von Gasemissionslöchern eingeführt wird.

6. Verfahren gemäß irgendeinem der Ansprüche 3 bis 5, worin der Gasfluss herbeigeführt wird durch Bereitstellen eines Blockiermittels zum Blockieren des Gasflusses auf der vorgeschalteten Seite, relativ zu der Basisfolien-Transportrichtung, von wo das Gas eingeführt wird.

7. Verfahren gemäß irgendeinem der Ansprüche 3 bis 6, worin der Gasfluss herbeigeführt wird durch Bereitstellen einer Auslasspassage zum Auslassen des Gases auf der nachgeschalteten Seite, relativ zu der Basisfolien-Transportrichtung, von wo das Gas eingeführt wird.

8. Verfahren gemäß irgendeinem der Ansprüche 3 bis 7, worin der Gasfluss herbeigeführt wird durch Einführen von mehr Gas auf der vorgeschalteten Seite, relativ zu der Basisfolien-Transportrichtung, als auf der nachgeschalteten Seite.

9. Verfahren gemäß irgendeinem der Ansprüche 3 bis 8, umfassend das Abscheiden der Siliziumnitridschicht, während eine lange Länge der Basisfolie in Längsrichtung transportiert wird.

10. Film- bzw. Folien-Abscheidungsvorrichtung, umfassend:
Mittel zum Transportieren einer Basisfolie in eine gegebene Richtung;
Mittel zum Abscheiden eines Films/einer Folie, umfassend Gaseinführmittel zum Einführen von Gas, aus dem Silanradikale generiert werden können, und ein Plasmagenerierendes Mittel; und
Mittel zum Herbeiführen eines Gasflusses in der gleichen Richtung wie die Transportrichtung der Basisfolie, ausgewählt aus zumindest einem von:
(i) einem Gasblockiermittel, das auf der vorgeschalteten Seite der Gaseinführmittel vorgesehen ist, relativ zur Basisfolien-Transportrichtung,
(ii) eine Auslasspassage zum Auslassen des Gases auf der nachgeschalteten Seite der Gaseinführmittel, relativ zu der Basisfolien-Transportrichtung, und
(iii) worin das Gaseinführmittel auch als Mittel zum Herbeiführen des Gasflusses dient und worin der Gasfluss herbeigeführt wird durch Einführen von mehr Gas auf der vorgeschalteten Seite, relativ zur Basisfolien-Transportrichtung, als auf der nachgeschalteten Seite.

11. Film- bzw. Folien-Abscheidungsvorrichtung gemäß Anspruch 10, worin das Plasma-generierende Mittel ein Paar Elektroden umfasst.

12. Film- bzw. Folien-Abscheidungsvorrichtung gemäß Anspruch 11, worin eine von dem Paar Elektroden eine Duschkopfelektrode mit einer Vielzahl von Gasemissionslöchern für das Gas ist.

13. Film- bzw. Folien-Abscheidungsvorrichtung gemäß irgendeinem der Ansprüche 10 bis 12, worin die Transportmittel eine zylindrische Trommel umfassen, über deren Umfangsoberfläche eine lange Länge der Basisfolie geführt wird, um die Basisfolie in Längsrichtung hiervon zu transportieren.

## Revendications

1. Film barrière contre les gaz comprenant :
un film de base ; et
une couche de nitrure de silicium déposée sur une surface du film de base,
dans lequel dans le sens de l'épaisseur de la couche de nitrure de silicium, la densité moyenne d'une première région de la couche de nitrure de silicium plus proche du film de base et ayant une épaisseur de 20 % de la couche de nitrure de silicium est supérieure à la densité moyenne d'une deuxième région opposée au film de base et ayant une épaisseur de 20 % de la couche de nitrure de silicium, et la densité moyenne d'une troisième région au milieu ayant une épaisseur de 20 % de la couche de nitrure de silicium est comprise entre les densités moyennes des première et deuxième régions.

2. Film barrière contre les gaz selon la revendication 1, dans lequel la densité moyenne de la première région est de 2,1 à 2,7 g/cm³ et la densité moyenne de la deuxième région est de 1,7 à 2,1 g/m³.

3. Procédé de préparation d'un film barrière contre les gaz selon la revendication 1, comprenant les étapes de :
transport d'un film de base dans un sens donné ;
circulation d'un gaz qui génère les radicaux silanes SiH₂ et SiH₃ dans le même sens que le sens de transport du film de base ; et
dépôt d'une couche de nitrure de silicium sur une surface du film de base par dépôt chimique en phase vapeur (CVD) activé par plasma en utilisant des radicaux silanes générés par le gaz, le nitrure de silicium de la première région étant déposé en présence d'une proportion relativement élevée de radicaux SiH₂ et le nitrure de silicium de la deuxième région étant déposé en présence d'une proportion relativement élevée de radicaux SiH₃.

4. Procédé selon la revendication 3, dans lequel la couche de nitrure de silicium est déposée par dépôt chimique en phase vapeur activé au plasma (CCP-CVD).

5. Procédé selon la revendication 4, dans lequel le gaz est introduit par le biais d'une électrode en pomme de douche comprenant une pluralité d'orifices d'émission de gaz.

6. Procédé selon l'une quelconque des revendications 3 à 5, dans lequel la circulation de gaz est créée par l'utilisation d'un moyen de blocage pour bloquer la circulation du gaz sur le côté en amont, par rapport au sens de transport du film de base, d'où le gaz est introduit.

7. Procédé selon l'une quelconque des revendications 3 à 6, dans lequel la circulation de gaz est créée par l'utilisation d'un passage de libération pour libérer le gaz sur le côté en aval, par rapport au sens de transport du film de base, d'où le gaz est introduit.

8. Procédé selon l'une quelconque des revendications 3 à 7, dans lequel la circulation de gaz est créée par l'introduction de plus de gaz sur le côté en amont, par rapport au sens de transport du film de base, que sur le côté en aval.

9. Procédé selon l'une quelconque des revendications 3 à 8, comprenant le dépôt de la couche de nitrure de silicium tandis qu'une longue longueur de film de base est transportée dans un sens longitudinal.

10. Dispositif de dépôt de film comprenant :
un moyen pour transporter un film de base dans un sens donné ;
un moyen pour déposer un film incluant un moyen d'introduction de gaz pour introduire un gaz à partir duquel des radicaux silanes peuvent être générés et un moyen de production de plasma ; et
un moyen de création d'une circulation de gaz pour créer une circulation de gaz dans le même sens que le sens de transport du film de base choisi parmi au moins l'un de :
(i) un moyen de blocage du gaz utilisé sur le côté en amont du moyen d'introduction de gaz par rapport au sens de transport du film de gaz,
(ii) un passage de libération pour libérer le gaz sur le côté en aval du moyen d'introduction de gaz par rapport au sens de transport du film de gaz, et
(iii) le moyen d'introduction de gaz agit également comme moyen de création d'une circulation de gaz et dans lequel la circulation du gaz est créée par l'introduction de plus de gaz sur le côté en amont, par rapport au sens de transport du film de base, que sur le côté en aval.

11. Dispositif de dépôt de film selon la revendication 10, dans lequel le moyen de production de plasma comprend une paire d'électrodes.

12. Dispositif de dépôt de film selon la revendication 11, dans lequel l'une des paires d_{'}électrodes est une électrode en pomme de douche comprenant une pluralité d'orifices d'émission de gaz pour le gaz.

13. Dispositif de dépôt de film selon l'une quelconque des revendications 10 à 12, dans lequel le moyen de transport comprend un tambour cylindrique sur lequel au niveau de sa surface périphérique passe une longue longueur de film de base pour transporter le film de base dans un sens longitudinal de celui-ci.
